Europäisches Patentamt

European Patent Office

Office européen des brevets

(19)

(11) **EP 0 956 625 B1**

(12) **EUROPÄISCHE PATENTSCHRIFT**

(45) Veröffentlichungstag und Bekanntmachung des Hinweises auf die Patenterteilung:
**21.04.2004 Patentblatt 2004/17**

(21) Anmeldenummer: **98963448.0**

(22) Anmeldetag: **12.11.1998**

(51) Int Cl.⁷: **H01S 5/06**, H01S 5/40

(86) Internationale Anmeldenummer:
**PCT/EP1998/007253**

(87) Internationale Veröffentlichungsnummer:
**WO 1999/028999 (10.06.1999 Gazette 1999/23)**

(54) **VERFAHREN ZUR WELLENLÄNGENABSTIMMUNG EINER OPTOELEKTRONISCHEN BAUELEMENTE-ANORDNUNG**

METHOD FOR SYNTONIZING THE WAVE LENGTHS OF AN ARRANGEMENT OF OPTOELECTRONIC COMPONENTS

PROCEDE POUR SYNTONISER LES LONGUEURS D'ONDE D'UN AGENCEMENT DE COMPOSANTS OPTO-ELECTRONIQUES

(84) Benannte Vertragsstaaten:
**AT CH DE DK FI FR GB IE IT LI NL SE**

(30) Priorität: **01.12.1997 DE 19755453**

(43) Veröffentlichungstag der Anmeldung:
**17.11.1999 Patentblatt 1999/46**

(73) Patentinhaber: **Deutsche Telekom AG**
**53113 Bonn (DE)**

(72) Erfinder:
• **HILLMER, Hartmut**
**D-64287 Darmstadt (DE)**
• **KLEPSER, Bernd**
**D-69151 Neckargemünd (DE)**

(56) Entgegenhaltungen:
**US-A- 5 536 085**

• **PATENT ABSTRACTS OF JAPAN vol. 014, no. 002 (E-868), 8. Januar 1989 & JP 01 251686 A (CANON INC), 6. Oktober 1989**
• **PATENT ABSTRACTS OF JAPAN vol. 009, no. 065 (E-304), 26. März 1985 & JP 59 204292 A (CANON KK), 19. November 1984**

## Beschreibung

Die Erfindung betrifft ein Verfahren zur Abstimmung einer optoelektronischen Bauelemente-Anordnung, die zumindest zwei optoelektronische Bauelemente und zumindest eine dem Bauelement zugeordnete einen elektrischen Leiter umfassende Widerstandsheizung zur Einstellung der charakterischen Wellenlänge des Bauelements umfaßt.

In zunehmendem Maße werden zur Datenübertragung beziehungsweise zur Übertragung von Fernseh- und Rundfunkkanälen optische Übertragungssysteme eingesetzt. Im allgemeinen besteht ein solches optisches Übertragungssystem aus einem lichtführenden Wellenleiter, einem Halbleiterlaser als Lichterzeuger und einem Lichtdetektor. Der Halbleiterlaser strahlt dabei Licht mit einer bestimmten, charakteristischen Wellenlänge aus. Diese charakteristische Wellenlänge ist im wesentlichen abhängig vom eingesetzten Material, läßt sich aber beispielsweise durch thermische Einwirkung innerhalb eines bestimmten Wellenlängenbereichs einstellen. Zur Erhöhung der über einen Wellenleiter übertragbaren Datenmenge lassen sich mehrere einem Wellenleiter zugeordnete Halbleiterlaser verwenden, die mit unterschiedlichen Wellenlängen arbeiten. Hierbei ist es jedoch notwendig, daß die Wellenlängen sehr genau eingehalten werden, so daß am Ende der Übertragung eine eindeutige Differenzierung der Daten möglich ist.

Da die charakteristische Wellenlänge von Halbleiterlasern herstellungsbedingt innerhalb eines Toleranzbereiches differiert, müssen die Halbleiterlaser vor dem Einsatz zur Datenübertragung abgestimmt werden. Hierzu bedient man sich beispielsweise sogenannter Widerstandsheizungen, die durch thermische Einwirkung mittels eines auf einem Substrat aufgebrachten elektrischen Leiters die charakteristische Wellenlänge eines Halbleiterlasers verändert. Die Abstimmung erfolgt im allgemeinen durch Einstellen der an dem elektrischen Leiter der Widerstandsheizung anliegenden Spannung, wobei hier jeder Widerstandsheizung eine Spannungsquelle zugeordnet ist.

Dies hat jedoch den Nachteil, daß ein sehr aufwendiger Aufbau notwendig wird. Desweiteren ist eine spätere Abstimmung der Anordnung in einfacher Weise nicht mehr möglich.

Patent Abstracts of Japan, vol. 14, no. 002 (E-868) & JP-A-01251686 offenbart ein Verfahren zur Wellenlängenabstimmung einer optoelektronischen Bauelemente-Anordung gemäß dem Oberbegriff des Anspruchs 1.

Die Aufgabe der vorliegenden Erfindung besteht deshalb darin, ein Verfahren zur Abstimmung von optoelektronischen Bauelementen anzugeben, das einfach ist und sich jederzeit durchführen läßt.

Diese Aufgabe der Erfindung wird durch ein Verfahren gelöst, das die Merkmale des Anspruchs 1 aufweist. Das Verfahren zeichnet sich dadurch aus, daß im ersten Schritt die Wellenlänge zumindest eines Bauelementes erfaßt wird und anhand dieses Wertes die Abweichung von der gewünschten Wellenlänge ermittelt wird. Anschließend wird in einem zweiten Schritt der Widerstandwert des dem jeweiligen Bauelement zugeordneten elektrischen Leiters der Widerstandsheizung H und/oder der Widerstandswert einer der Widerstandsheizung H vorgeschalteten Widerstandsanordnung RM abhängig von der ermittelten Wellenlängenabweichung verändert.

Durch die gezielte Änderung der Heizleistung der Widerstandsheizung H wird die gewünschte Änderung der charakteristischen Wellenlänge bewirkt.

Dieses Verfahren erlaubt eine sehr einfache Einstellung mehrerer optoelektronischer Bauelemente auf einer Bauelemente-Anordnung, beispielsweise einer Halbleiterlaserzeile. Insbesondere läßt sich das Verfahren vollautomatisch durchführen, was große Vorteile bei der Verwendung von optoelektronischen Bauelementen in größerem Umfang hat.

Besonders vorteilhaft ist es, den Widerstandswert des elektrischen Leiters der Widerstandsheizung H durch Materialveränderung, beispielsweise genau bemessenen Materialabtrag oder Materialauftrag zu verändern.

Weitere vorteilhafte Ausgestaltungen des erfindungsgemäßen Verfahrens ergeben sich aus den Unteransprüchen. Die Erfindung wird nun anhand von Ausführungsbeispielen mit Bezug auf die Zeichnungen näher erläutert. Dabei zeigen:

Figur 1          ein Blockdiagramm einer optoelektronischen Bauelemente-Anordnung,

Figur 2a          eine schematische Darstellung einer Widerstandseinrichtung,

Figur 2b          ein Schaltbild der Widerstandseinrichtung,

Figur 2c          Darstellung, wie sich die Heizleistungen verschiedener Kanäle gegenseitig beeinflussen,

Figur 3          ein erstes Ausführungsbeispiel einer Bauelemente-Anordnung,

Figur 4a          ein weiteres Ausführungsbeispiel einer Bauelemente-Anordnung,

Figur 4b bis 4d    drei Diagramme zur Bestimmung der Heizleistung,

Figur 5a          ein weiteres Ausführungsbeispiel einer Bauelemente-Anordnung,

Figur 5b                ein Diagramm zur Berechnung der Heizleistung,

Figur 6                 ein weiteres Ausführungsbeispiel einer Bauelemente-Anordnung,

Figur 7                 ein weiteres Ausführungsbeispiel einer Bauelemente-Anordnung,

Figur 8                 ein weiteres Ausführungsbeispiel einer Bauelemente-Anordnung,

Figur 9                 ein weiteres Ausführungsbeispiel einer Bauelemente-Anordnung,

Figur 10                ein weiteres Ausführungsbeispiel einer Bauelemente-Anordnung,

Figur 11                ein weiteres Ausführungsbeispiel einer Bauelemente-Anordnung,

Figur 12a               eine schematische Darstellung einer Bauelemente-Anordnung mit einer als Heizung dienenden Widerstandsanordnung, und

Figur 12b               ein Diagramm zur Veranschaulichung des Verfahrens.

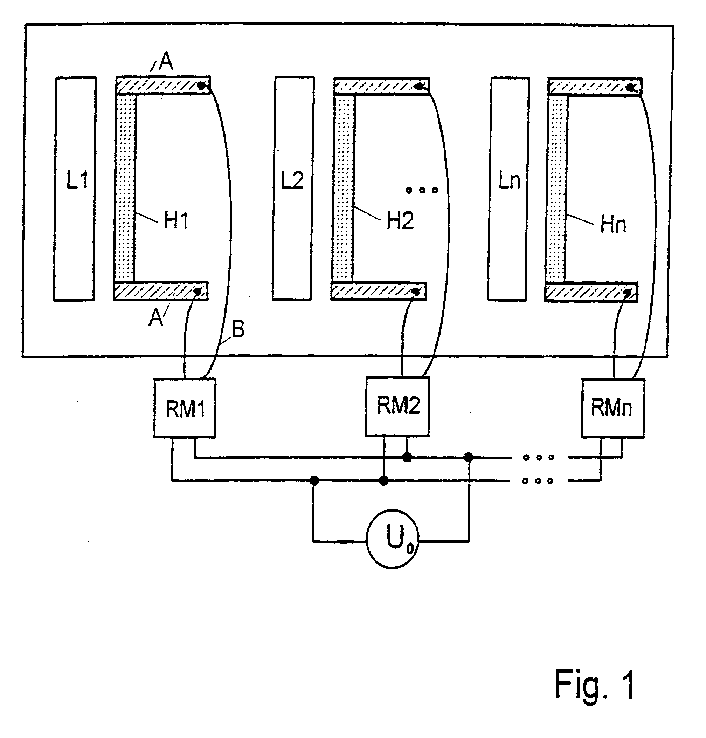

In Figur 1 ist eine Bauelemente-Anordnung 1 dargestellt, die eine Anzahl von Halbleiterlasern L1 bis Ln umfaßt. Der grundsätzliche Aufbau einer solchen Halbleiterlaserzeile ist bekannt, weshalb an dieser Stelle auf deren genaue Beschreibung verzichtet wird. Zur gleichzeitigen Übertragung von Daten in einem optischen Datenübertragungssystem arbeiten die Halbleiterlaser L1 bis Ln mit unterschiedlichen Wellenlängen beziehungsweise Frequenzen. Herstellungsbedingt strahlen die Halbleiterlaser L1 bis Ln nicht immer mit der gewünschten Wellenlänge aus. Vor und/oder während der Inbetriebnahme erfolgt deshalb eine Abstimmung auf die gewünschte Wellenlänge durch Verändern der charakteristischen Wellenlänge, wobei im vorliegenden Fall zur Abstimmung der thermische Effekt ausgenutzt wird. Durch entsprechende individuelle Beaufschlagung der Halbleiterlaser L1 bis Ln mit einer bestimmten Temperatur läßt sich die charakteristische Wellenlänge innerhalb eines bestimmten Bereichs variieren. Hierzu ist jedem Halbleiterlaser L1 bis Ln zumindest eine Widerstandsheizung H1 bis Hn zugeordnet. Die Widerstandsheizungen H1-Hn bestehen jeweils aus einem elektrischen Leiter (im folgenden auch Stromleiter genannt), der einen entsprechend hohen elektrischen Widerstand aufweist, bei Anlegen einer Spannung Wärme entwickelt und im Halbleiterlaser L1 bis Ln das gewünschte Temperaturfeld erzeugt. Die Spannungsversorgung der Widerstandsheizungen H1 bis Hn kann beispielsweise indirekt über Widerstandsanordnungen RM1-RMn erfolgen (Fig. 1) die von einer gemeinsamen Spannungsversorgung $U_0$ gespeist werden. Jede der Widerstandsanordnungen RM1-RMn ist vorzugsweise als Widerstandsarray aufgebaut, welches aus einzelnen Widerstandelementen besteht. Die Veränderung des Gesamtwiderstandes, beispielsweise der Widerstandsanordnung RM1, bewirkt eine Veränderung der Heizleistung der Widerstandsheizung H1. Dadurch verändert sich auch der durch die Widerstandsheizung H1 fließende Strom.
Die Einstellung der Widerstandsanordnungen RM1-RMn auf bestimmte Widerstandswerte erfolgt elektrisch, optisch und/oder durch elektromagnetische Wellen.

Die Widerstandsanordnungen RM1-RMn lassen sich einerseits auf einem die Halbleiterlaser L1-Ln tragenden Träger anordnen. Desweiteren ist es möglich, die Widerstandsanordnungen RM1-RMn getrennt von den Halbleiterlasern L1 bis Ln vorzusehen, beispielsweise an einer später sehr leicht zugänglichen Stelle der gesamten Einheit zur Datenübertragung.

Die zur Erwärmung der Stromleiter der Widerstandsheizungen H1-Hn notwendige von der Spannungsquelle $U_0$ bereitgestellte elektrische Spannung wird über Stromzuführungen zugeführt. Beispielsweise werden diese Stromzuführungen aus den Bereichen A und den Bondverbindungen B gebildet. Die Bereiche A sind als Verbindungen und leitfähige Bereiche ausgebildet, die im eigentlichen Sinne keine Widerstände sind. Die Stromleiter der Widerstandsheizungen H1-Hn bestehen aus einer Anzahl im mathematischen Sinne mehrfach zusammenhängender elektrisch leitfähiger Gebiete, die elektrisch miteinander verbunden sind und jeweils einen Gesamtwiderstand $R_H$ aufweisen. Abhängig von diesem Widerstand $R_H$ und der angelegten Spannung $U_0$ erzeugt jeder Stromleiter eine Heizleistung $P_H$, die Einfluß auf die charakteristische Wellenlänge der Halbleiterlaser L1-Ln besitzt.

Zur Einstellung der Heizleistung jeder Widerstandsheizung H1-Hn auf einen gewünschten Wert läßt sich einerseits die Spannung der Spannungsversorgung $U_0$ und/oder der Widerstandswert $R_H$ der Stromleiter der Widerstandsheizungen H1-Hn verändern.

Zur individuellen Einstellung der Heizleistung der einzelnen Widerstandsheizungen H1-Hn ist es vorteilhaft, deren Widerstand $R_H$ zu verändern, da ein Verändern der Spannung sich auf die Heizleistung aller Widerstandsheizungen H1 bis Hn auswirkt.

Erfindungsgemäß erfolgt das Einstellen des Widerstands $R_H$ durch Materialauf- und/oder Materialabtrag an bestimmten Stellen des Stromleiters oder gleichmäßig über den Stromleiter der Widerstandsheizungen H1-Hn. So läßt sich durch Auftragen von leitfähigem Material der von einem Strom durchflossene Querschnitt des Stromleiters vergrößern und damit dessen elektrischer Widerstand verringern. Umgekehrt läßt sich durch Abtragen von Material der stromdurchflossene Querschnitt des Stromleiters verkleinern und damit dessen Widerstand vergrößern. Mit Hilfe eines Lasers ist es beispielsweise möglich, örtlich gezielt Material abzutragen. Selbstverständlich sind auch andere Verfahren neben der Laserablation denkbar.

Neben dem Materialauftrag beziehungsweise Materialabtrag, also der Veränderung des stromdurchflossenen Querschnitts des Stromleiters ist es auch möglich, das Material des Stromleiters zu verändern, beispielsweise durch Materialmischen oder Materialentmischen. Bei entsprechender Auswahl des Materials für den Stromleiter ist dessen Widerstand beispielsweise durch Erwärmung, Abkühlung, chemische Behandlung, elektrochemische Behandlung, Teilchenimplantation, elektromagnetische Strahlung und/oder Teilchenstrahlung einstellbar.

Neben der räumlichen Anordnung der Stromleiter der Widerstandsheizungen H1-Hn und der Veränderung der Widerstände der Stromleiter lassen sich zur Erzeugung des gewünschten Temperaturfelds auch Widerstände in die Stromzuführungen zu den elektrischen Leitern der Widerstandsheizungen H1-Hn einschalten, was mittels der Widerstandsanordnungen RM1-RMn möglich ist.

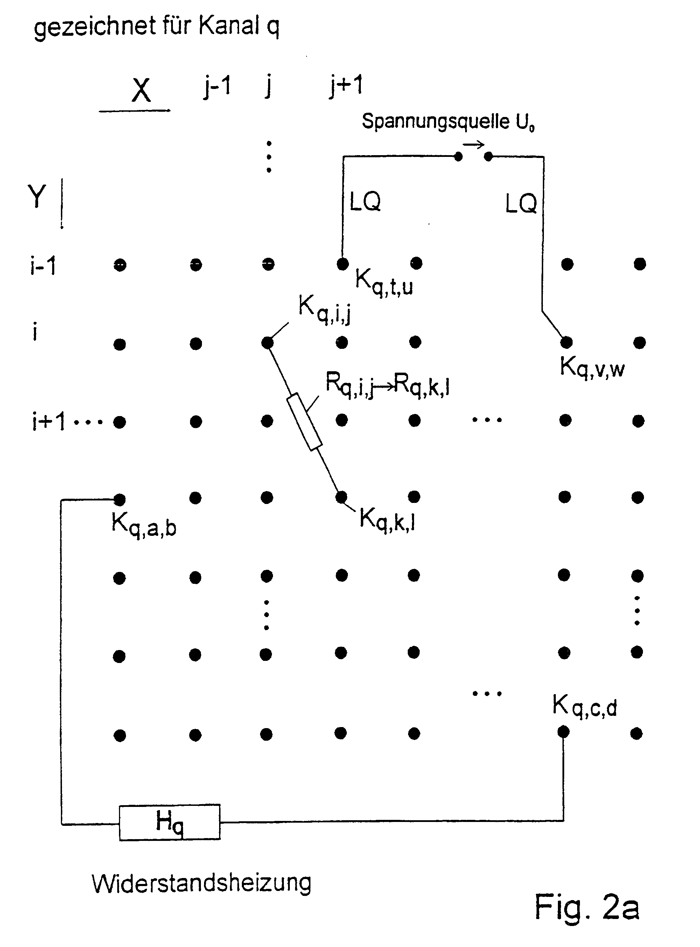

Wie bereits erwähnt, läßt sich die charakteristische Wellenlänge $\lambda_q$ jedes einzelnen Halbleiterlasers über die Temperatur des betreffenden Halbleiterlasers Lq somit über die Heizleistung $P_H$ beziehungsweise den Heizstrom $I_H$ durch die dem Halbleiterlaser Lq zugeordnete Widerstandsheizung Hq individuell einstellen. Die Grundlage für jeden Kanal q, mit $q \in [1,n]$ den Heizstrom individuell einzustellen, läßt sich beispielsweise über eine matrixartige Anordnung, wie in Figur 2a für den Kanal q dargestellt, realisieren. Die matrixartige Anordnung besteht aus Kontaktfeldern $K_{q,i,j}$ mit den Koordinaten (i,j), wobei $i \in [1,r]$ und $j \in [1,s]$ ist, q die Bauelemente-Nummer (Kanal) angibt und r bzw. s die Größe der matrixartigen Widerstandsanordnung in y- bzw. x-Richtung ist. Die eingezeichneten Indizes j und i bezeichnen die Spalten und Zeilennummern. Diese matrixartige Anordnung von Kontaktfeldern wird im folgenden als Kontaktmatrix bezeichnet. Die Kontaktfelder sind über ohmsche Widerstände $R_{q,i,j \to q,k,l}$ gekoppelt, wobei $R_{q,i,j \to q,k,l}$ einen Widerstand zwischen den Kontaktfeldern $K_{q,i,j}$ und $K_{q,k,l}$ bezeichnet. Die Widerstandswerte der ohmschen Widerstände umfassen Werte $R_{q,i,j \to q,k,l} = 0$ Ohm (Kurzschluß) bis $R_{q,i,j \to q,k,l} \to \infty$ (keine elektrisch leitende Verbindung oder Isolator). Die Kontaktfelder $K_{q,t,u}$ und $K_{q,v,w}$ mit $(t,u) \neq (v,w)$ sind mit einer elektrischen Spannungsquelle $U_0$ verbunden, die zwischen den Kontaktfeldern eine Potentialdifferenz U(t) beliebigen zeitlichen Verlaufs erzeugt. Die elektrischen Verbindungen der Spannungsquelle $U_0$ mit den Kontaktfeldern $K_{q,t,u}$ und $K_{q,v,w}$ werden im folgenden mit LQ bezeichnet. Eine elektrische Verbindung LQ besteht aus einer Zahl $f \geq 1$ im mathematischen Sinne mehrfach zusammenhängender elektrisch leitfähiger Gebiete, die elektrisch miteinander verbunden sind. Diese Gebiete enthalten eine Anzahl $g \geq 0$ elektrisch leitender Gebiete der Widerstandheizung Hq eines Kanals q und eine Anzahl $h \geq 0$ elektrisch leitender Gebiete der matrixartigen Anordnung aus Kontaktfeldern.

Die Kontaktfelder $K_{q,a,b}$ und $K_{q,c,d}$ mit $(a,b) \neq (c,d)$ sind über eine elektrisch leitende Verbindung mit der Widerstandsheizung Hq derart verbunden, daß eine Potentialdifferenz zwischen den Punkten $K_{q,a,b}$ und $K_{q,c,d}$ einen elektrischen Stromfluß durch die Widerstandsheizung Hq hervorruft, falls der Widerstandswert $R_{H,q}$ der Widerstandsheizung Hq endlich groß ist.

Die Anordnung aus Spannungsquelle $U_0$, elektrischen Verbindungen LQ, matrixförmiger Anordnung aus Kontaktfeldern, den ohmschen Widerständen $R_{q,i,j \to q,k,l}$ zwischen den Kontaktfeldern $K_{q,i,j}$ und $K_{q,k,l}$ wird erfindungsgemäß derart manipuliert beziehungsweise abgestimmt, daß sich an der elektrischen Widerstandsheizung Hq eine Heizleistung $P_q$ einstellt, die durch die thermische Ankopplung der Widerstandsheizung $H_q$ am Halbleiterlaser $L_q$ eine Temperaturänderung $\Delta T_q$ am Halbleiterlaser $L_q$ hervorruft. Diese Temperaturänderung bewirkt eine Wellenlängenverschiebung $\Delta \lambda_q$ der charakteristischen Wellenlänge des Kanals q.

Die individuelle Einstellung der Wellenlänge $\lambda_q$ des Kanals q durch Verändern des Widerstands des Stromleiters und/oder der Widerstandsanordnung läuft nach folgendem Verfahren ab:

Zu Beginn des Verfahrens wird eine Heizleistung $P_q \geq 0$ eingestellt, aus der sich eine Wellenlänge $\lambda_q$ ergibt. Das Ziel ist, die Heizleistung derart einzustellen, daß die Wellenlänge $\lambda_{q,s}$ beträgt.

Die Heizleistung der Widerstandsheizung wird in einem Bereich variiert, in dem die damit verbundene Wellenlängenänderung den Bereich der gewünschten Wellenlänge $\lambda_{q,s}$ abdeckt. Aus dieser Messung ergibt sich ein funktioneller Zusammenhang $\lambda_q(P_q)$. Entsprechend läßt sich aus diesem Zusammenhang für eine Wellenlänge $\lambda_{q,s}$ die Heizleistung $P_q$ bestimmen. Die gewünschte Heizleistung $P_q$ läßt sich durch Verändern des Widerstands der Widerstandsanordnung RMq und/oder des Widerstands $R_{H,q}$ des Stromleiters der Widerstandsheizung einstellen. Auch durch Einstellen der Spannung an der Spannungsversorgung $U_0$ läßt sich die Heizleistung $P_q$ variieren, wobei jedoch entsprechend auch die Heizleistung der anderen optoelektronischen Bauelemente verändert wird. Beispielsweise wird bei der Widerstandsanordnung RMq durch die Größe der angelegten Spannung an den Kontaktfeldern $K_{q,t,u}$ und $K_{q,v,w}$ die Dimensionierung und Anordnung der Widerstände $R_{q,i,j \to q,k,l}$ und durch Überbrückungen (Kurzschlüsse) zwischen den Kontaktfeldern sowie Bemessung der Größe des Heizwiderstandes $R_{H,q}$ der Widerstandsheizung Hq der maximale Betrag der Leistungsvariation $\Delta P_q = P_{q,max} - P_{q,min}$ eines Kanals q festgelegt. Aus dieser Leistungsvariation $\Delta P_q$ ergibt

sich eine maximale Wellenlängenvariation $\Delta\lambda_{q,max}$.

Eine weitere Möglichkeit, die charakteristische Wellenlänge einzustellen, besteht darin, die Heizleistung $P_q$ auf einen bestimmten Wert $P \geq 0$ einzustellen und die dazugehörige Wellenlänge zu messen. Dann wird auf der Grundlage von abgespeicherten Erfahrungswerten zu dem funktionellen Zusammenhang $\lambda_q(Pq)$ die Heizleistung verändert.

Es ist auch denkbar, die Heizleistung $P_q$ nacheinander auf zwei Werte einzustellen und jeweils die zugehörige Wellenlänge zu messen. Fließend wird der Verlauf des funktionellen Zusammenhangs $\lambda_q(p_q)$ durch Interpolation und/oder Extrapolation der zuvor ermittelten Wellenlängen berechnet und entsprechend die Heizleistung $P_q$ verändert.

Ebenfalls ist es denkbar, die Heizleistung $P_q$ in bestimmten Schritten $\Delta P$ zu variieren und die entsprechende Wellenlänge zur Erstellung des funktionellen Zusammenhangs $\lambda_q(P_q)$ zu messen und anhand des ermittelten Zusammenhangs die Heizleistung $P_q$ zu verändern.

Selbstverständlich ist es auch möglich, die Heizleistung $P_q$ kontinuierlich zu variieren, bis die gewünschte Wellenlänge erreicht ist.

Bei der Einstellung der Heizleistung $P_q$ muß für die Widerstandswerte der Verbindungen LQ zwischen der Spannungsquelle $U_0$ und der matrixartigen Anordnung von Kontaktfeldern $K_{q,i,j}$ und $K_{q,k,l}$ sowie dem Innenwiderstand der Spannungsquelle $U_0$ folgende Forderung erfüllt sein: Haben bei einer Bauelementanordnung von n Kanälen mit n Widerstandsheizungen und n Anordnungen von Kontaktfeldern eine Anzahl von n-1 Widerstandsheizungen H eine Heizleistung $P_{e,min}$ und eine beliebige Widerstandsheizung $H_s$ die Heizleistung $P_s$ mit $P_{s,min}<P_s<P_{s,max}$ und $s \neq e$, dann müssen die elektrischen Verbindungen LQ der Spannungsquelle $U_0$ mit den Kontaktfeldern der einzelnen Kanäle q sowie der Innenwiderstand der Spannungsquelle $U_0$ derart dimensioniert sein, daß bei einer Variation der Heizleistung der n-1 Kanäle um $\Delta P_e$, also von $P_{e,min}$ nach $P_{e,max}$, die Heizleistung der Widerstandsheizung $H_s$ um einen Wert $\Delta P_{s,Fehler}<\varepsilon_s \cdot \Delta P_s$ variiert, mit einem Wert $0<\varepsilon_s<1$, der frei wählbar ist, jedoch möglichst klein sein sollte, um eine gegenseitige Beeinflussung der Kanäle zu minimieren.

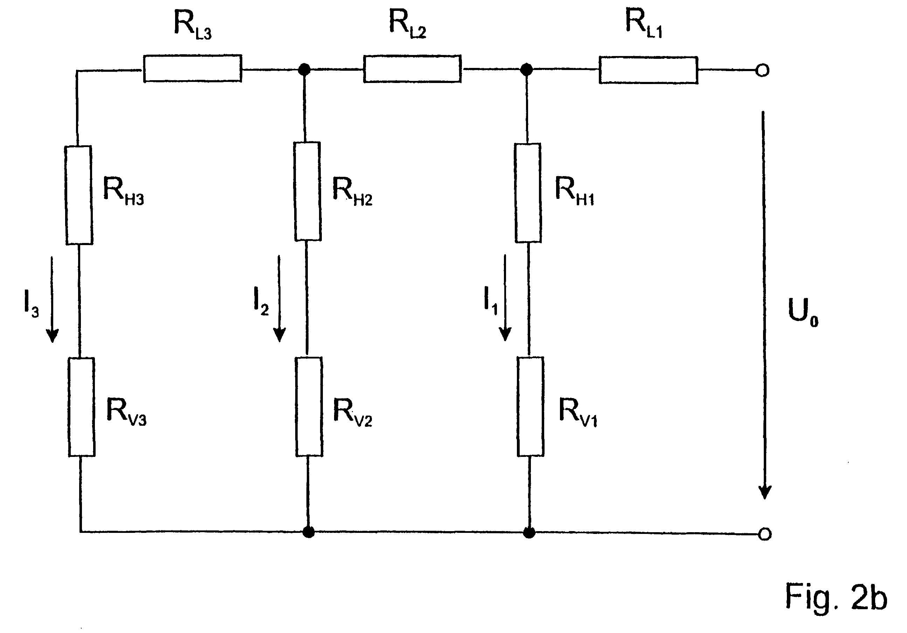

In Figur 2b ist das Schaltbild eines Ausführungsbeispiels mit drei Widerstandsheizungen dargestellt. Die matrixartigen Anordnungen von Kontaktfeldern mit Widerständen $R_{q,i,j \rightarrow q,k,l}$ (q=1,2,3) zwischen den Kontaktfeldern sind in diesem einfachen Fall derart gestaltet, daß sie zu Gesamtwiderständen (im folgenden mit Vorwiderständen $R_{v1}$-$R_{v3}$ bezeichnet, die zum Heizwiderstand $R_{H1}$-$R_{H3}$ in Serie geschaltet sind), zusammengefaßt werden können. Die elektrischen Verbindungen LQ der Spannungsquelle $U_0$ mit den Kontaktfeldern zu den Vorwiderständen $R_{v1}$-$R_{v3}$ und Heizwiderständen $R_{H1}$-$R_{H3}$ haben einen Leitungswiderstand $R_{L1}$-$R_{L3}$. Der Innenwiderstand der Spannungsquelle $U_0$ ist im Widerstand $R_{L1}$ enthalten.

Die Widerstandswerte der Vorwiderstände $R_{v1}$-$R_{v3}$ und Heizwiderstände $R_{H1}$-$R_{H3}$ werden entsprechend der nötigen Heizleistungen $P_1$-$P_3$ beziehungsweise Wellenlängenverschiebung und der Größe der zur Verfügung stehenden Spannung $U_0$ dimensioniert. Die Leitungwiderstände $R_{L1}$ bis $R_{L3}$ müssen obige Forderung erfüllen. Die Leistungen der Heizwiderstände $R_{H1}$-$R_{H3}$ ergeben sich aus:

$$P_q = I_q^2 R_{H,q}$$

mit $q= 1,2,3$ $\qquad R_{H,q}$ = Widerstand der q-ten Heizung $H_q$
und den Strömen

$$I_1 = \frac{U_0}{R_\gamma}\left(1 - \frac{R_{L1}}{R_{ges}}\right)$$

$$I_2 = \frac{U_0}{R_\beta}\left[1 - \frac{R_{L1}}{R_{ges}} - \frac{R_{L2}}{R_{ges}} + 1 - \frac{R_{L2}}{R_\gamma}\left(1 - \frac{R_{L1}}{R_{ges}}\right)\right]$$

$$I_3 = \frac{U_0}{R_\alpha + R_{L3}}\left[1 - \frac{R_{L1}}{R_{ges}} - \frac{R_{L2}}{R_{ges}} + \frac{R_{L2}}{R_\gamma}\left(1 - \frac{R_{L1}}{R_{ges}}\right)\right]$$

und

$$R_\alpha = R_{L3} + R_{V_3} + R_{H_3}$$

$$R_\beta = R_{V2} + R_{H_2}$$

$$R_\gamma = R_{V1} + R_{H_1}$$

$$R_{ges} = \text{Gesamtwiderstand}$$

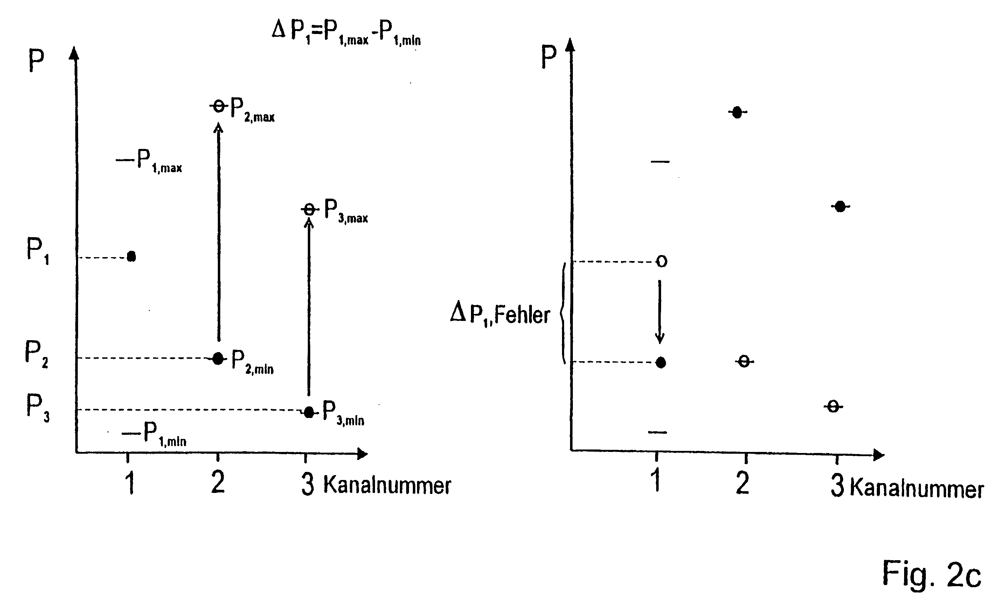

In Figur 2c ist die genannte Forderung für Kanal 1 dargestellt. Die Heizleistung $P_1$ von Kanal 1 hat einen beliebigen Wert innerhalb von $\Delta P_1$. Die restlichen Kanäle 2 und 3 haben eine Heizleistung von $P_{2,min}$ beziehungsweise $P_{3,min}$. Wird die Heizleistung der Kanäle 2 und 3 auf $P_{2,max}$ beziehungsweise $P_{3,max}$ erhöht, so muß die Abweichung von $P_1$ kleiner sein als $\varepsilon_1 \bullet \Delta P_1$.

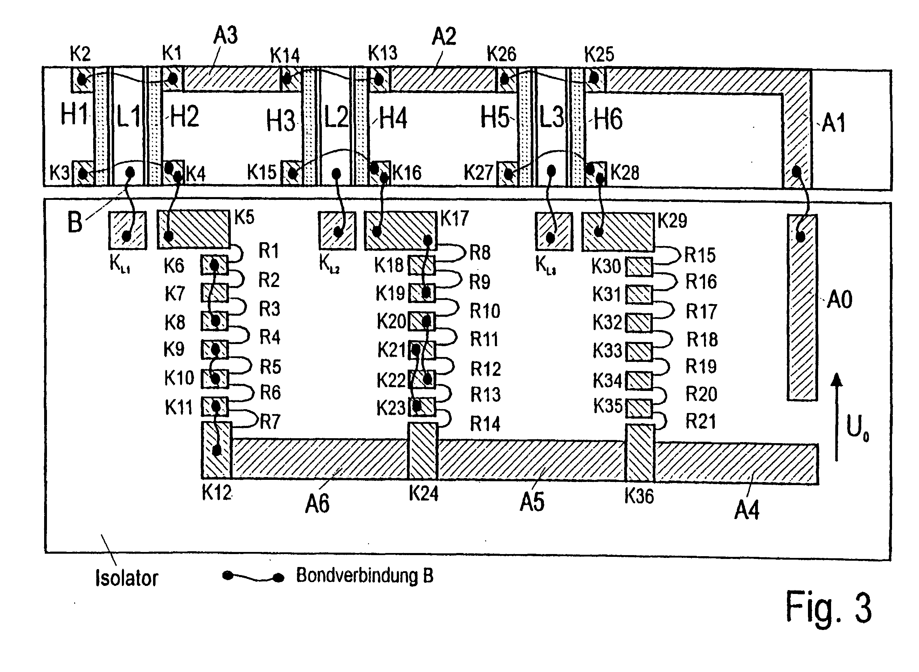

Eine entsprechende Umsetzung der vorgenannten Ausführungen in eine Bauelemente-Anordnung ist in den Figuren 3 bis 11 dargestellt, die im folgenden näher beschrieben werden.

Figur 3 zeigt eine Bauelemente-Anordnung 1, die drei Bauelemente, vorzugsweise Halbleiterlaser, L1, L2 und L3 umfaßt. Der Aufbau der Anordnung selbst ist zweigeteilt, wobei im ersten Teil die drei Halbleiterlaser L1 bis L3 vorgesehen sind. Desweiteren umfaßt der erste Teil der Anordnung Widerstandsheizungen H1 bis H6 sowie einen Teil der Kontaktmatrix (K1 - K4, K13 - K16, K25 - K28), wobei H1, H2 und K1-K4 zu Kanal 1 gehören, H3, H4 und K13-K16 Kanal 2 zugeordnet sind und H5, H6 sowie K25-K28 zu Kanal 3 zugeordnet sind. Die Widerstandsheizungen H1 bis H6 sind so angeordnet, daß sie in thermischem Kontakt zu den ihnen jeweils zugeordneten Halbleiterlasern L1 bis L3 stehen.

Der zweite Teil des Aufbaus besteht aus einem Isolator, auf dem sich für jeden Kanal, das heißt für jeden Halbleiterlaser L1 bis L3 der zweite Teil der Kontaktfelder der Kontaktmatrix befindet (K5 bis K12 für Kanal 1, K17 bis K24 für Kanal 2 und K29 bis K36 für Kanal 3). Im vorliegenden Fall besteht die Kontaktmatrix aus einer eindimensionalen Matrix mit zwölf Feldern. Die Zuleitungen LQ zur Spannungsquelle $U_0$ befinden sich am oberen Rand der Laserzeile und am unteren Rand der Kontaktzeile. Die Zuleitungen umfassen die Bereiche: A0, B, A1, K25, B, K26, A2, K13, B, K14, A3, K1, B, K2 am oberen Rand der Bauelementeanordnung des Teils 1 und die Bereiche A4, K36, A5, K24, A6 und K12 am unteren Rand des Isolators.

Die Zuleitungen enthalten somit Gebiete der Kontaktmatrizen.

Neben den Kontaktmatrizen befinden sich auf der Kontaktanordnung weitere Kontaktfelder $K_{L1}$ bis $K_{L3}$, die über elektrisch leitende Bondverbindungen B mit den Kontakten der entsprechenden Halbleiterlaser L1-L3 verbunden sind. Die Kontakte K5 bis K12 von Kanal 1, K17 bis K24 von Kanal 2 und K29 bis K36 von Kanal 3 der Kontaktmatrizen sind durch räumlich verteilte Widerstandsanordnungen R1-R7, R8-R14 und R15-R21 elektrisch leitend verbunden. In Figur 3 sind die Widerstandsanordnungen als schwarze Schleifen dargestellt. Das Kontaktfeld K4 ist mit Kontaktfeld K5 über eine Bondverbindung elektrisch verbunden, gleiches gilt für K16 und K17 sowie K28 und K29. Die Versorgungsspannung der Widerstandsheizungen H1-H6 wird zwischen den Bereichen A4 und A0 angelegt, was durch einen Pfeil angedeutet ist.

Die Einstellung der einzelnen Widerstandsheizungen H1-H6 auf eine bestimmte Heizleistung $P_q$ erfolgt durch das Verändern der Widerstände zwischen den Kontakten der Kontaktmatrix, was durch zusätzliche elektrische Verbindungen oder durch Verändern der schleifenförmigen Widerstandsanordnungen erzielt werden kann.

Die während des Abstimmungsverfahrens notwendige Variation der Heizleistung wird durch eine variable Spannung an der Spannungsquelle $U_0$ eingestellt.

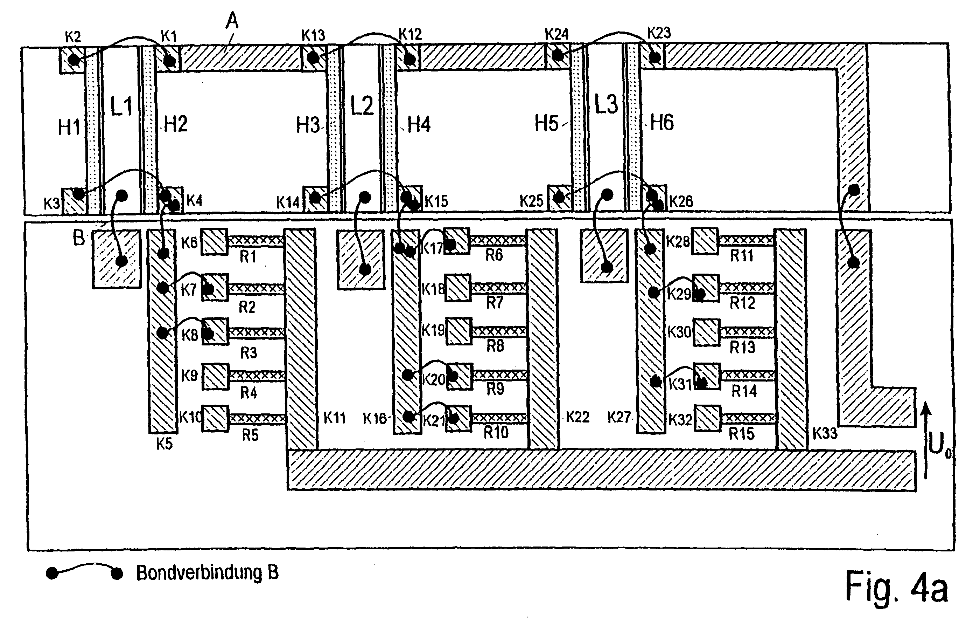

Das in Figur 4a gezeigte Ausführungsbeispiel folgt in wesentlichen Teilen dem Beispiel in Figur 3. Es unterscheidet sich durch die Anordnung der Kontaktmatrizen, die in diesem Fall aus jeweils 11 Kontaktfeldern bestehen (K1 bis K 11 für Kanal 1, K12 bis K22 für Kanal 2 und K23 bis K33 für Kanal 3). Zwischen dem Kontaktfeld K11 und den Kontaktfeldern K6 bis K10, K22 und K17 bis K21 sowie K33 und K28 bis K32 befinden sich ohmsche Widerstände mit den Werten:

$$R1 = R6 = R11 = {}^1/_1 \bullet R$$

$$R2 = R7 = R12 = \tfrac{1}{2} \cdot R$$

$$R3 = R8 = R13 = \tfrac{1}{4} \cdot R$$

$$R4 = R9 = R14 = \tfrac{1}{8} \cdot R$$

$$R5 = R10 = R15 = {}^{1}\!/_{16} \cdot R,$$

wobei der Widerstand R durch den maximal und minimal einzustellenden Widerstand festgelegt ist.

Es handelt sich somit um eine binäre Kodierung der Widerstandswerte, mit der es möglich ist, einen Widerstandsbereich von R bis $R/2^i$ aufzuspannen, wobei i die Zahl der Widerstände pro Kanal ist. Mit fünf Widerständen lassen sich so einunddreißig verschiedene Widerstandswerte einstellen, indem beispielsweise für Kanal 1 elektrisch leitende Verbindungen vom Kontaktfeld K5 zu den Kontaktfeldern K6 bis K10 hergestellt werden. Soll zum Beispiel der Widerstandswert $\tfrac{1}{6} \cdot R$ für Kanal 1 eingestellt werden, so ist -wie in Figur 4a am Halbleiterlaser L1 ausgeführt- der Widerstand $R2 = \tfrac{1}{2} \cdot R$

mit dem Widerstand $R3 = \tfrac{1}{4} \cdot R$ parallel zu schalten. Bei Halbleiterlaser L2 ist ein Widerstandswert von $1/25 \cdot R$ und bei Halbleiterlaser L3 ein Widerstandswert von $1/10 \cdot R$ eingestellt.

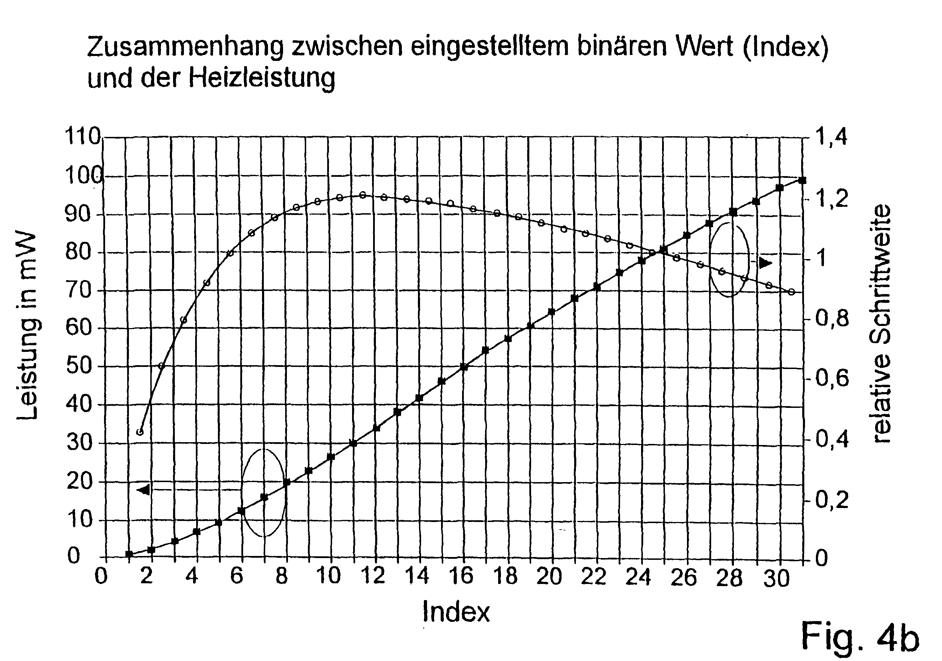

Für den Fall, daß $U_0 = 2.5$ V, R = 480 Ohm und $R_H = 20$ Ohm ist, ist in Figur 4b der Heizleistungsverlauf auf der linken Ordinatenachse in Abhängigkeit von dem eingestellten Index dargestellt. Der Widerstandswert ergibt sich zu $R_{res} = R/_{Index}$. Die Leistung berechnet sich gemäß:

$$P(R) \;=\; \frac{U_0^2}{\left(R_{res} + R_H\right)} R_H$$

mit $R_{res}$ als dem resultierenden Widerstand.

Auf der rechten Ordinatenachse der Figur 4b ist die relative Schrittweite aufgetragen. Eine relative Schrittweite von Eins entspricht der Schrittweite des linearen Zusammenhangs zwischen der Heizleistung und des eingestellten Index. Durch die Dimensionierung der Heizwiderstände H1-H6, der Spannung $U_0$ sowie des Widerstandes R ist eine gute Übereinstimmung mit dem linearen Verlauf erzielt worden.

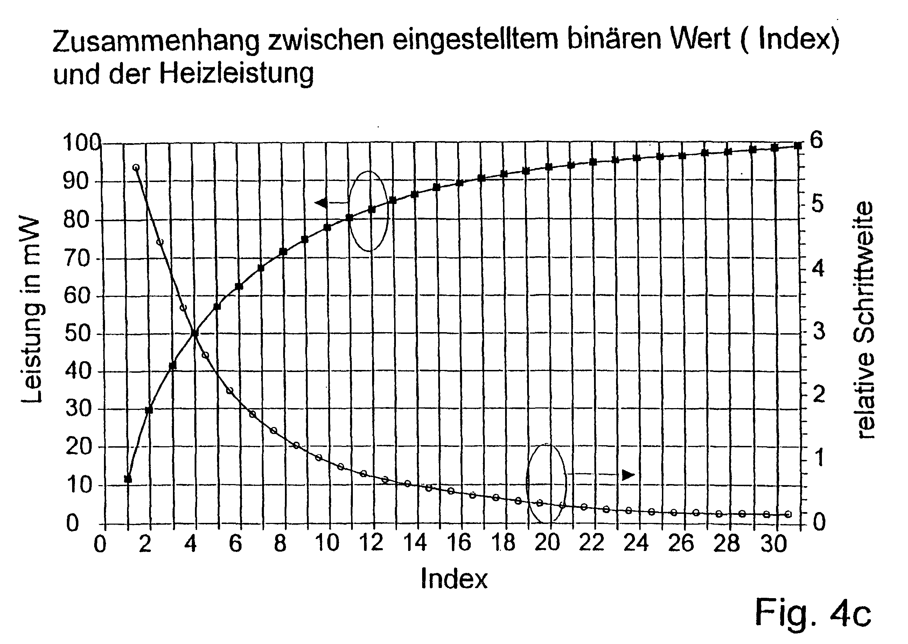

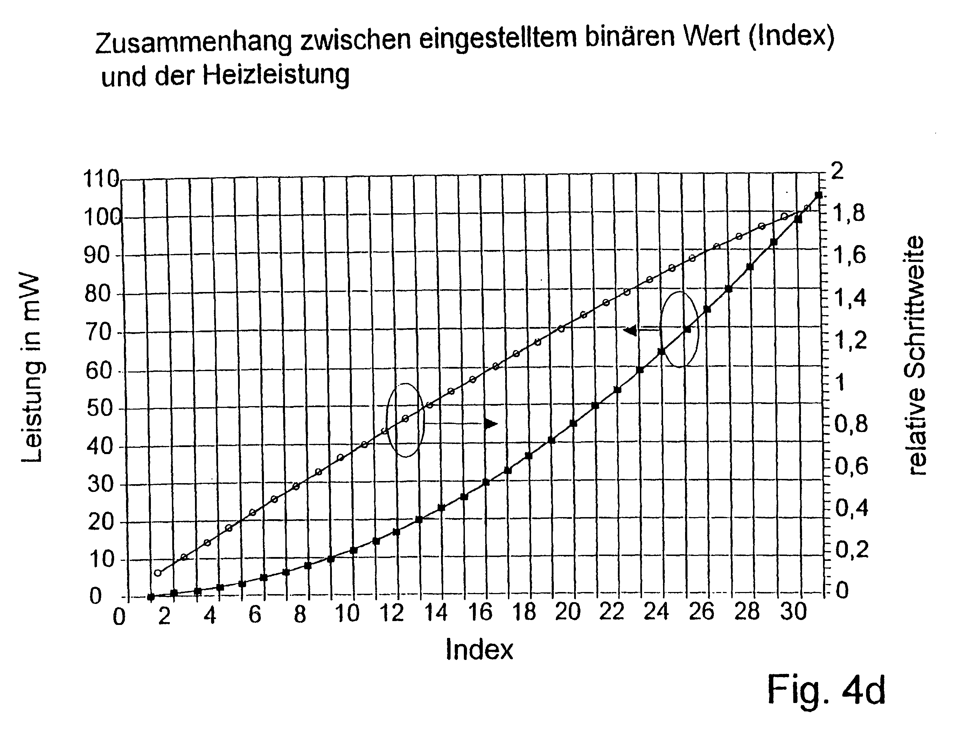

Es kann von Vorteil sein, die Heizleistung $P_q$, zum Beispiel für hohe Heizleistungen, in überproportional kleinen (großen) Schrittweiten einzustellen, wie es in Figur 4c (Figur 4d) durch die Wahl der Versorgungsspannung und des Wertes für R geschehen ist. Für den Fall großer Schrittweiten bei hohen Heizleistungen (Figur 4d) beträgt die Heizspannung 20 V und der Widerstandwert von R = 8 kOhm. Im Fall kleiner Schrittweiten bei hohen Heizleistungen beträgt die Heizspannung 1,5 V und der Widerstandswert für R = 40 Ohm.

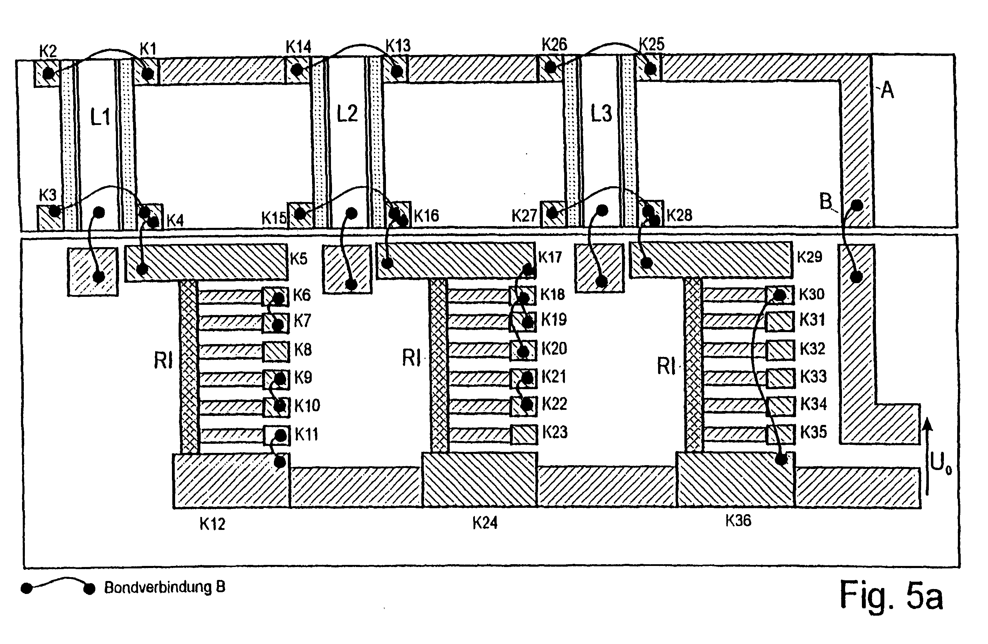

Figur 5a zeigt eine Variation von Figur 3. Die schleifenförmigen Widerstände von Fig. 3 sind in Fig. 5a als gerade Widerstandsanordnungen RI ausgeführt. Die Kontaktfelder K5 bis K 12 greifen beispielsweise für Kanal 1 den Widerstand RI an unterschiedlichen Stellen ab. Auch bei diesem Beispiel können die resultierenden Widerstandswerte binär kodiert werden, sofern die Widerstände zwischen zwei benachbarten Kontaktfeldern aus K5 bis K12 für Kanal 1, K17 bis K24 für Kanal 2 und K29 bis K36 für Kanal 3 dimensioniert sind, wie beispielhaft für Kanal 1 gezeigt.

R1 = Widerstand zwischen K5 und K6 = R
R2 = Widerstand zwischen K6 und K7 = R • 2
R3 = Widerstand zwischen K7 und K8 = R • 4
R4 = Widerstand zwischen K8 und K9 = R • 8
R5 = Widerstand zwischen K9 und K10 = R • 16
R6 = Widerstand zwischen K10 und K11 = R • 32
R7 = Widerstand zwischen K11 und K12 = R • 64

Zum Beispiel ergibt sich für Halbleiterlaser L1 ein resultierender Widerstand von R1 + R3 + R4 + R6. Entsprechendes gilt für die restlichen Kanäle.

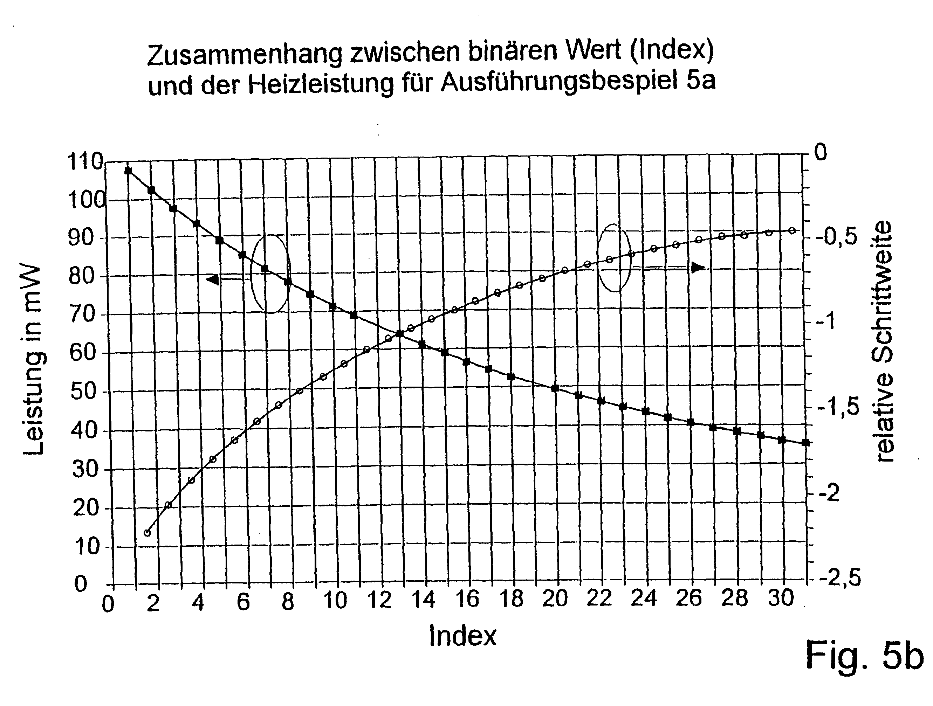

Figur 5b zeigt den Leistungsverlauf für den Fall der binären Kodierung. Anhand von Kanal 2 wird gezeigt, wie durch beliebig überschneidende Verbindungen zwischen den Kontaktfeldern K17 und K19 sowie K18 und K20 weitere Gesamtwiderstandswerte realisiert werden können.

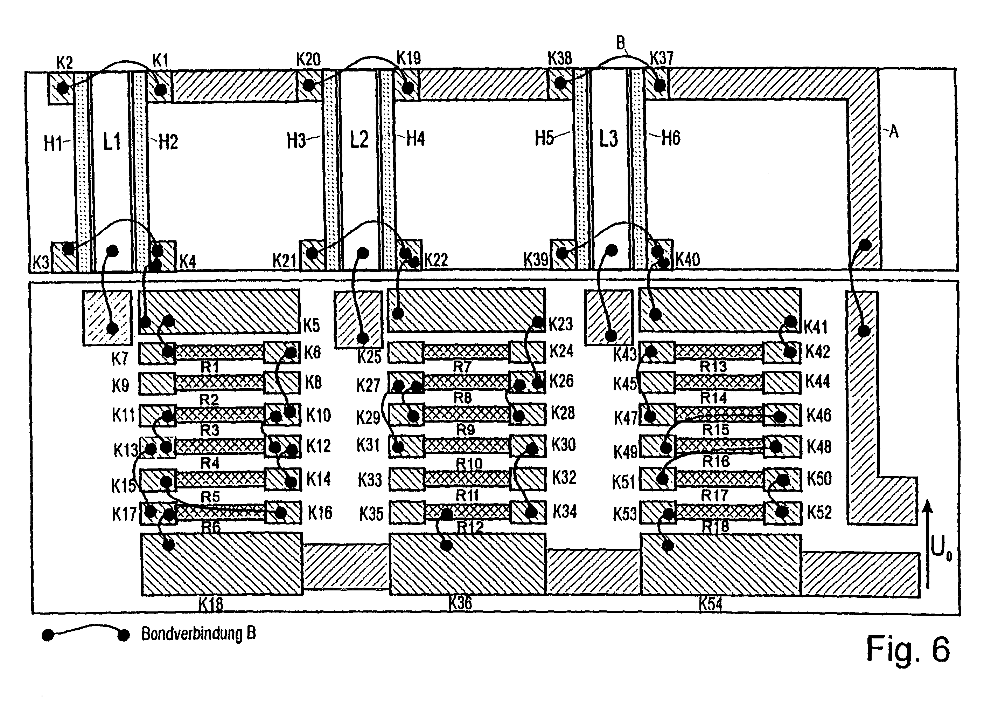

In Figur 6 ist ein weiteres Ausführungsbeispiel einer Bauelemente-Anordnung gezeigt, wobei zur Einstellung der Heizleistung $P_q$ sechs Widerstände pro Kanal (R1 bis R6 für Kanal 1; R7 bis R12 für Kanal 2 und R13 bis R18 für Kanal 3) zur Verfügung stehen.

Über die Kontaktfelder K5 bis K18 (beispielsweise für Kanal 1) können die Widerstände beliebig miteinander verbunden werden.

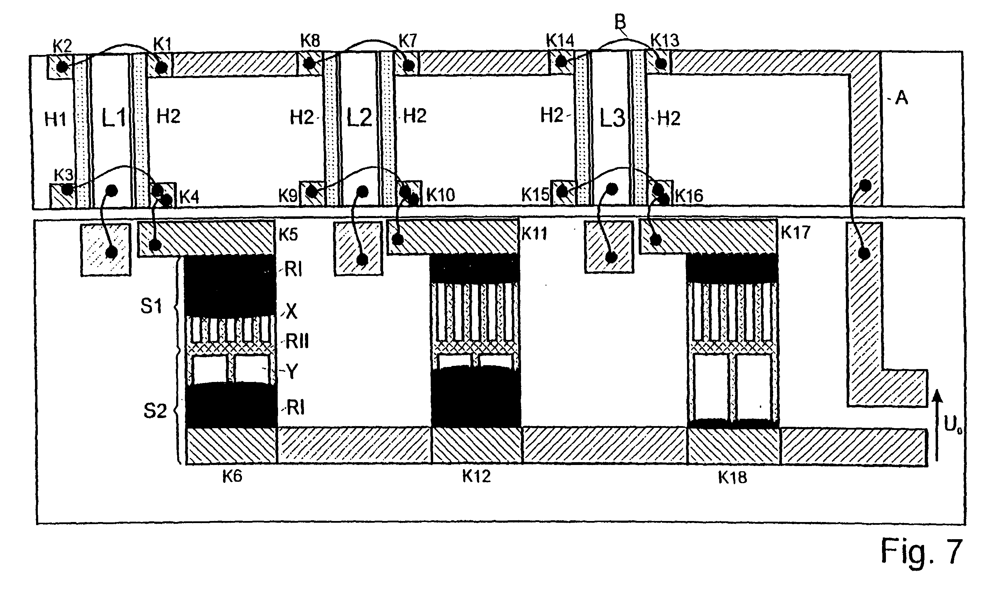

Die in Figur 7 dargestellte Kontaktmatrix besteht aus 6 Kontaktfeldern pro Kanal. Die Felder K5 und K6 (für Kanal 1) sind mittels einer abstimmbaren Widerstandsanordnung elektrisch leitend miteinander verbunden. Die Widerstandsanordnung setzt sich aus zwei Gebieten S1 und S2 zusammen, die wiederum aus einem Gebiet mit elektrisch leitendem Material X (schraffiert) und einem isolierenden Bereich mit einem Isolator Y (weiß) bestehen. Durch das Aufbringen eines hochleitfähigen Materials (schwarz), zum Beispiel Lot auf die Bereiche S1 und S2, wird der Gesamtwiderstand zwischen den Kontaktfeldern verkleinert. Der Bereich S2 dient zur Grobeinstellung und der Bereich S1 zur Feinabstimmung der Heizleistung.

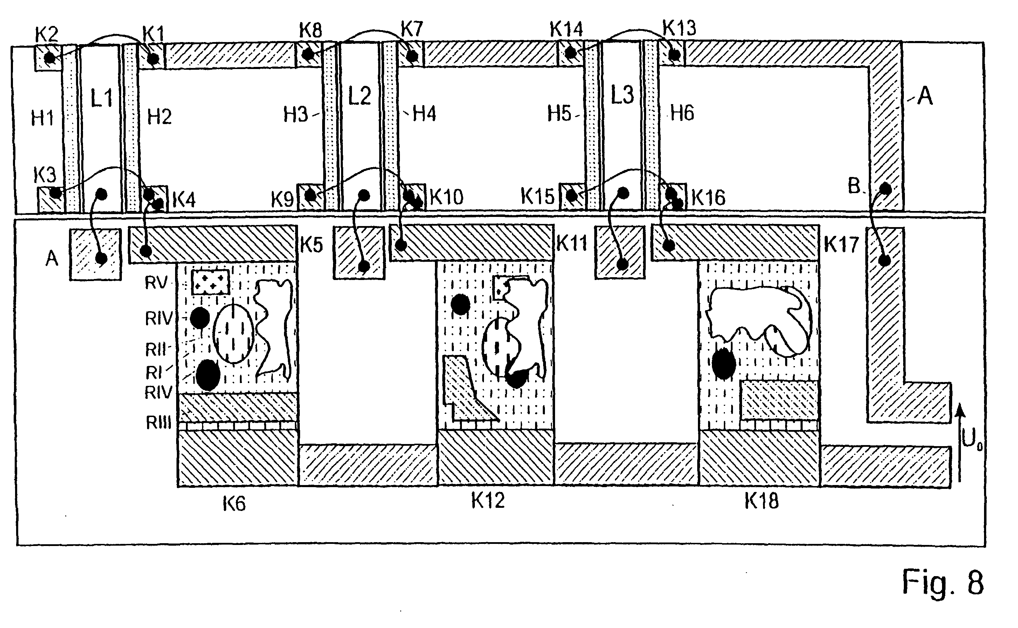

Das Ausführungsbeispiel gemäß Figur 8 ist gegenüber jenem gemäß Figur 7 dahingehend abgeändert, daß die Abstimmung durch Verändern des Widerstandes von beliebig geformten Gebieten, die als unterschiedlich gekennzeichnete Flächen dargestellt sind und die elektrische Leitfähigkeiten (RI bis RV) besitzen, auf der Widerstandsanordnung RM erfolgt. Diese Widerstände RI-RV bestehen aus unterschiedlichem Widerstandsmaterial. Die Widerstandswerte der Widerstände RI-RV lassen sich zum Beispiel durch gezielte Materialveränderung, vorzugsweise Materialaboder Materialauftrag auf den gewünschten Widerstandswert einstellen. Materialabtrag bzw. Materialauftrag kann beispielsweise durch Laserablation realisiert werden. Weiterhin ist es möglich, den Widerstandswert der Widerstände RI-RV durch thermische Behandlung, chemische Behandlung oder elektrochemische Behandlung zu ändern. Weitere Möglichkeiten zur Änderung des Widerstandswertes werden in der Beeinflussung durch Teilchenimplatation, elektromagnetische Strahlung bzw. Teilchenstrahlung oder durch ein elektrisches Signal gesehen.

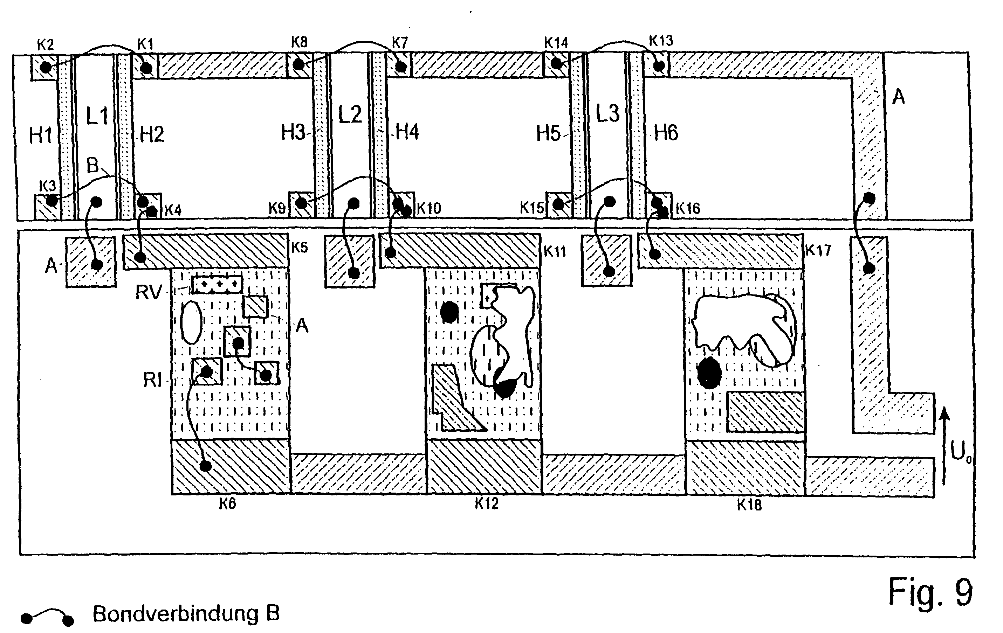

Das Ausführungsbeispiel gemäß Figur 9 unterscheidet sich von jenem gemäß Figur 8 dadurch, daß beliebige elektrisch leitfähige Verbindungen zwischen den aus unterschiedlichem Widerstandsmaterial bestehenden beliebig geformten Widerständen angebracht werden. Bei den Verbindungen kann es sich zum Beispiel um Bondverbindungen B handeln. Die Abstimmung erfolgt durch Anbringen oder Entfernen von Bondverbindungen oder alternativ nach dem Verfahren, wie in Figur 8 beschrieben.

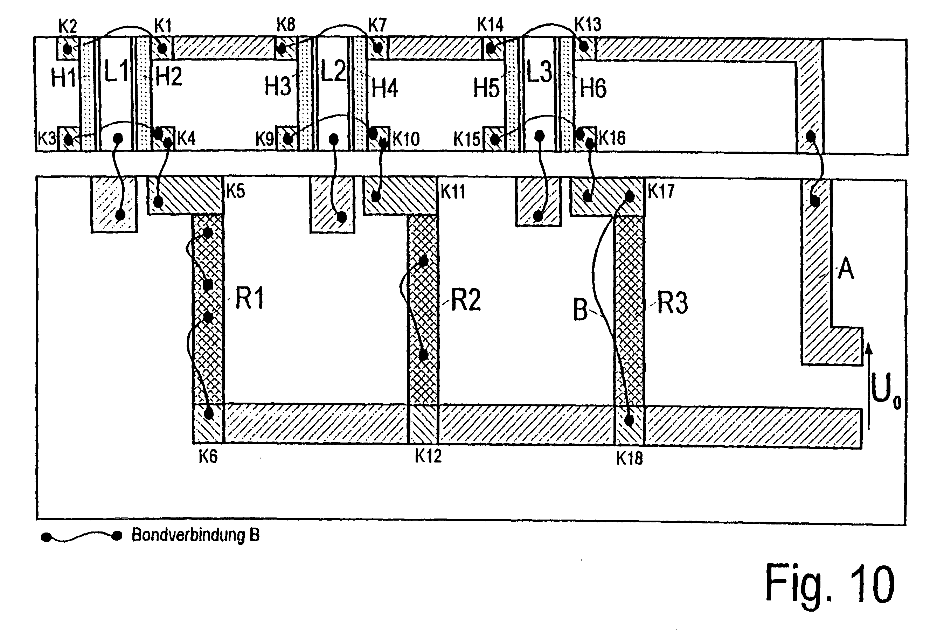

In dem in Figur 10 gezeigten Ausführungsbeispiel werden die Widerstandsanordnungen RM für die 3 Kanäle durch die Widerstände R1 bis R3 ausgebildet. Die Abstimmung erfolgt dadurch, daß elektrisch leitfähige Verbindungen, zum Beispiel Bondverbindungen B mit einer im Vergleich zur Widerstandsanordnung RM hohen elektrischen Leitfähigkeit angebracht werden.

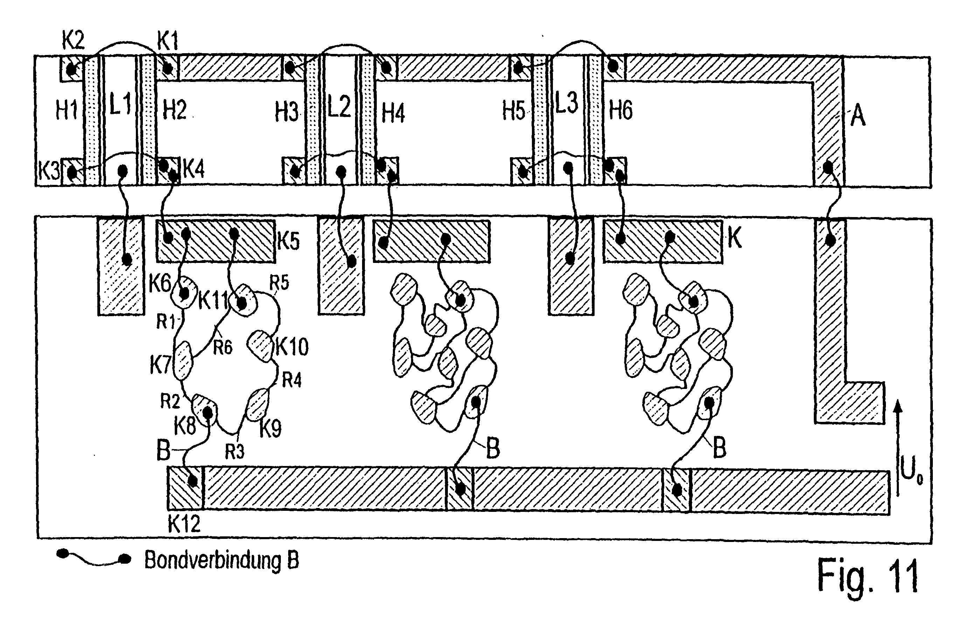

In Figur 11 ist ein weiteres Ausführungsbeispiel dargestellt, bei dem die Kontaktmatrix für Kanal 1 die Kontaktfelder K1 bis K12 umfaßt. Zwischen den Kontaktfeldern K6 und K11 befinden sich elektrisch leitende Verbindungen R1 bis R6, die in Fig. 11 als gekrümmte Linien dargestellt sind. Durch zusätzliche elektrische Verbindungen, die als Bondverbindungen B ausgebildet sind, wird der Gesamtwiderstand der Kontaktmatrix abgeglichen.

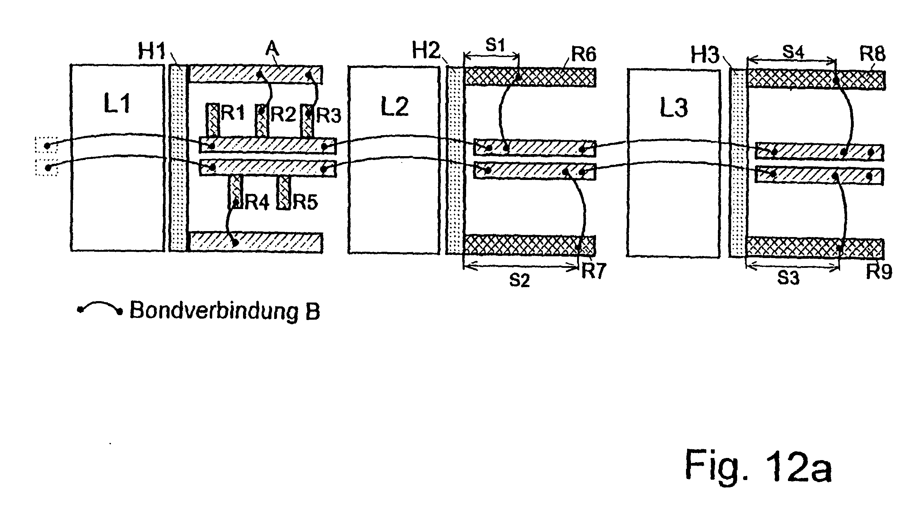

Die vorgenannten Verfahren zur Veränderung des Widerstands des Stromleiters der Widerstandsheizung und der Veränderung des Widerstands innerhalb der Widerstandsanordnung RM lassen sich sowohl einzeln als auch in beliebiger Kombination zum Abstimmen eines Halbleiterlasers einsetzen. Darüber hinaus ist es auch denkbar, die beschriebene Widerstandsanordnung RM in thermischen Kontakt mit den Halbleiterlasern zu bringen, so daß die Widerstandsanordnung RM als weitere Heizung zur Erwärmung der Halbleiterlaser dient, wie dies schematisch in Figur 12a dargestellt ist.

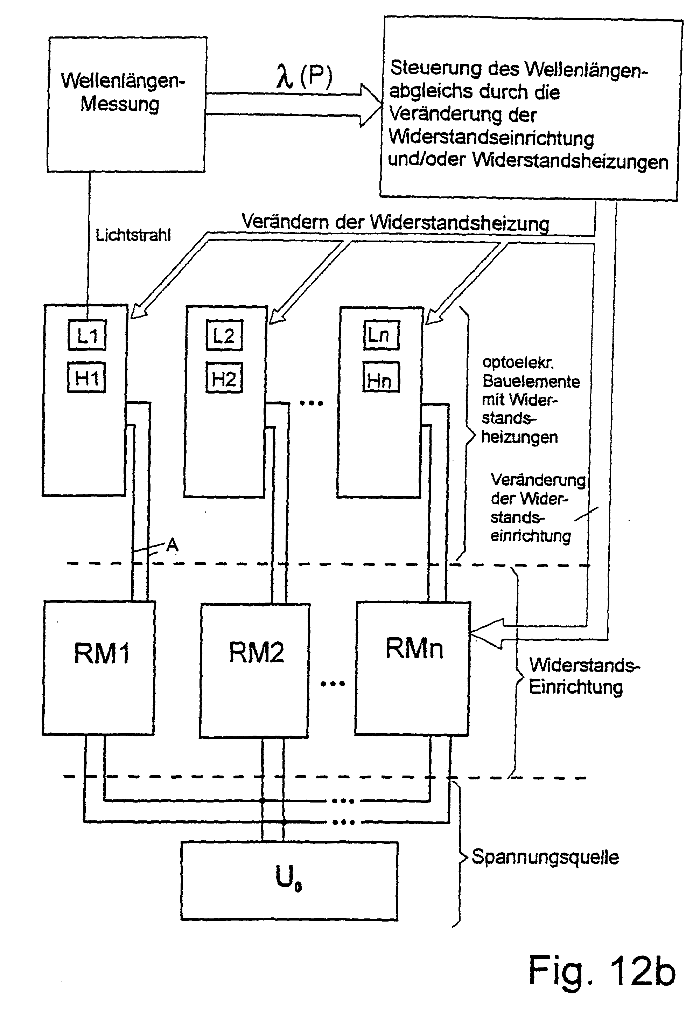

Das zuvor beschriebene Verfahren zum Abstimmen der Halbleiterlaser L soll nun anhand der Figur 12b nochmals kurz erläutert werden. So wird zunächst eine bestimmte Heizleistung $P \geq 0$ mittels der Spannungsquelle $U_0$ oder alternativ über die Widerstandsanordnung RM1-RMn individuell für jeden Halbleiterlaser L1 bis Ln eingestellt. Anschließend erfolgt eine Wellenlängenmessung für jeden Halbleiterlaser L1 bis Ln. Anhand des funktionellen Zusammenhangs $\lambda(P)$ wird dann der Widerstandswert des dem entsprechenden Halbleiterlaser L1-Ln zugeordneten elektrischen Leiters (Widerstandsheizung H1-Hn) nach einem der vorgenannten Verfahren verändert. Je nach gewähltem Verfahren werden diese Schritte mehrmals ausgeführt, bis schließlich die gewünschte charakteristische Wellenlänge erreicht ist.

An dem vorgenannten Ausführungsbeispiel wird deutlich, daß es eine Vielzahl von Möglichkeiten gibt, mit Hilfe einer Materialveränderung der Stromleiter und/oder einer Widerstandsanordnung die Heizleistung der einzelnen Widerstandsheizungen auf einfache Weise individuell einzustellen, ohne auf mehrere Spannungsquellen $U_0$ zurückgreifen zu müssen. Insbesondere lassen sich die Widerstandswerte sowohl der Widerstandsanordnungen RM1-RMn als auch der Widerstandsheizungen H1-Hn jederzeit, also auch nachträglich, nach Inbetriebnahme der Bauelemente-Anordnung verändern. So ist es beispielsweise denkbar, durch Zeit- und Temperaturmessungen auf der Grundlage von Erfahrungswerten die Wellenlänge beziehungsweise die Heizleistung $P_q$ in regelmäßigen Abständen zu überprüfen und ggf. zu verändern, um beispielsweise Alterungseffekte zu kompensieren.

Darüber hinaus ist die vorliegende Erfindung nicht nur auf die beschriebenen Halbleiterlaser L1-Ln anwendbar, sondern allgemein auf optoelektronische Bauelemente, wie optische Verstärker, Filter, Wellenlängenmultiplexer oder Wellenleiter.

Bei den vorgenannten Ausführungsbeispielen wurde als Energieversorgungseinrichtung jeweils eine Spannungsquelle $U_0$ verwendet. Selbstverständlich ist es ebenso möglich, eine Stromquelle I einzusetzen, wie es in Figur 13 dargestellt ist, wobei dann Widerstandsanordnung RM1-RM3 und Widerstandsheizung H1-H3 parallel und nicht in Reihe zueinander liegen.

**Aufstellung der verwendeten Bezugszeichen**

| | |
|---|---|
| L1-Ln | Halbleiterlaser |
| $U_0$ | Spannungsquelle |
| I | Stromquelle |
| H | Widerstandsheizung |
| H1-Hn | Widerstandsheizungen der Halbleiterlaser |
| Hq | Widerstandsheizung eines Kanals q |
| $R_{H,q}$ | Widerstand der Widerstandsheizung eines Kanals q |
| Pq | Heizleistung der Widerstandsheizung eines Kanals q |
| LQ | elektrische Verbindungen der Spannungsquelle $U_0$ mit den Kontaktfeldern der einzelnen Kanäle q |
| $R_{q,i,j}$-$R_{q,k,l}$ | Widerstände der Widerstandsheizungen |
| $R_{V1}$-$R_{V3}$ | Vorwiderstände |
| $R_{L1}$-$R_{L3}$ | Leitungswiderstände von $R_q$ |
| RM | Widerstandsanordnung |
| RM1-RMn | Widerstandsanordnungen der optoelektronischen Bauelemente |
| R1-Rn | Widerstände der Widerstandsanordnungen |
| RI-RXVII | Widerstände der Widerstandsanordnungen aus unterschiedlichem Widerstandsmaterial |
| A1-An | Verbindungen und leitfähige Bereiche, die im eigentlichen Sinne keine Widerstände sind |
| B | Bondverbindungen |
| K1-Kn | Kontaktfelder Bondpads |
| $K_{L1}$-$K_{L3}$ | Kontaktfelder |
| $K_{q,a,b}$-$K_{q,v,w}$ | Kontaktfelder |
| x,y | Ortskoordinate |
| S1;S2 | Weg |

**Patentansprüche**

1. Verfahren zur Wellenlängenabstimmung einer optoelektronischen Bauelemente-Anordnung, mit zumindest zwei optoelektronischen Bauelementen $L_1$, ..., $L_n$, bei dem die Einstellung der charakteristischen Wellenlänge für jedes optoelektronische Bauelement unter Anwendung des Prinzips der thermischen Einstellung der charakteristischen Wellenlänge über separat zugeordnete Widerstandsheizungen $H_1$, ..., $H_n$ erfolgt und bei dem die Wellenlängenabweichung anhand des Vergleichs der gemessenen Wellenlänge mit der charakteristischen Wellenlänge ermittelt wird, **dadurch gekennzeichnet, daß** die zur Einstellung der charakteristischen Wellenlänge des optoelektronischen Bauelements notwendige thermische Änderung der Widerstandsheizung $H_1$, ..., $H_n$ durch gezielte Änderung des Widerstandswertes des Leiters der Widerstandsheizung $H_1$, ..., $H_n$ und/oder gezielte Änderung des Widerstandswertes einer der Widerstandsheizung $H_1$, ..., $H_n$ vorgeschalteten Widerstandsanordnung $RM_1$, ..., $RM_n$ erfolgt.

2. Verfahren nach Anspruch 1, **dadurch gekennzeichnet, daß** der Widerstandswert des Leiters der Widerstandsheizung $H_1$, ..., $H_n$ und/oder der Widerstandswert der Widerstandsanordnung $RM_1$, ..., $RM_n$ durch Materialveränderung, vorzugsweise Materialab- oder Materialauftrag, geändert werden.

3. Verfahren nach Anspruch 1, **dadurch gekennzeichnet, daß** der Widerstandswert durch Laserablation geändert wird.

**4.** Verfahren nach Anspruch 1, **dadurch gekennzeichnet, daß** der Widerstandswert durch thermische Behandlung geändert wird.

**5.** Verfahren nach Anspruch 1, **dadurch gekennzeichnet, daß** der Widerstandswert durch chemische oder elektrochemische Behandlung geändert wird.

**6.** Verfahren nach Anspruch 1, **dadurch gekennzeichnet, daß** der Widerstandswert durch Teilchenimplantation, elektromagnetische Strahlung bzw. Teilchenstrahlung geändert wird.

**7.** Verfahren nach Anspruch 1, **dadurch gekennzeichnet, daß** der Widerstandswert durch ein elektrisches Signal geändert wird.

**8.** Verfahren nach Anspruch 1, **dadurch gekennzeichnet, daß** der Widerstandswert der Widerstandsanordnung $RM_1$, ..., $RM_n$ durch schaltungstechnische Maßnahmen geändert wird.

**9.** Verfahren nach einem der vorhergehenden Ansprüche, **dadurch gekennzeichnet, daß** es in regelmäßigen Zeitabständen durchgeführt wird.

**Claims**

**1.** Process for the wavelength tuning of an optoelectronic component arrangement, with at least two optoelectronic components $L_1$, ..., $L_n$, wherein the characteristic wavelength is set for each optoelectronic component using the principle of the thermal setting of the characteristic wavelength by means of separately assigned resistance heaters $H_1$, ..., $H_n$, the wavelength deviation being determined on the basis of a comparison of the measured wavelength with the characteristic wavelength, **characterized in that** the thermal change of the resistance heater $H_1$, ..., $H_n$ required for setting the characteristic wavelength of the optoelectronic component is accomplished by selectively changing the resistance value of the conductor of the resistance heater $H_1$, ..., $H_n$ and/or by selectively changing the resistance value of a resistor arrangement $RM_1$, ..., $RM_n$ connected upstream of the resistance heater $H_1$, ..., $H_n$.

**2.** Process according to claim 1, **characterized in that** the change of the resistance value of the conductor of the resistance heater $H_1$, ..., $H_n$ and/or the change of the resistance value of the resistor arrangement $RM_1$, ..., $RM_n$ is accomplished by a change of material, preferably the removal or application of material.

**3.** Process according to claim 1, **characterized in that** the change of the resistance value is accomplished by laser ablation.

**4.** Process according to claim 1, **characterized in that** the change of the resistance value is accomplished by heat treatment.

**5.** Process according to claim 1, **characterized in that** the change of the resistance value is accomplished by chemical or electrochemical treatment.

**6.** Process according to claim 1, **characterized in that** the change of the resistance value is accomplished by particle implantation, electromagnetic radiation or particle radiation.

**7.** Process according to claim 1, **characterized in that** the change of the resistance value is accomplished by an electrical signal.

**8.** Process according to claim 1, **characterized in that** the change of the resistance value of the resistor arrangement $RM_1$, ..., $RM_n$ is accomplished by circuitry-related measures.

**9.** Process according to any one of the preceding claims, **characterized in that** said process is carried out at regular intervals.

**Revendications**

1. Procédé pour le réglage en longueur d'onde d'un dispositif optoélectronique comportant au moins deux composants optoélectroniques ($L_1$, ..., $L_n$), où le réglage de la longueur d'onde caractéristique de chaque composant optoélectronique s'effectue par l'application du principe de réglage thermique de la longueur d'onde caractéristique au moyen de chauffages par résistance assignés séparément ($H_1$,..., $H_n$) et où l'écart de longueur d'onde est déterminé à l'aide de la comparaison de la longueur d'onde mesurée avec la longueur d'onde caractéristique, **caractérisé en ce que** la modification thermique du chauffage par résistance ($H_1$, ..., $H_n$) nécessaire au réglage de la longueur d'onde caractéristique du composant optoélectronique s'effectue par une modification spécifique de la valeur de la résistance du conducteur du chauffage de résistance ($H_1$, ..., $H_n$) et/ou par une modification spécifique de la valeur de la résistance de la disposition de résistances montée en amont du chauffage par résistance ($H_1$, ..., $H_n$).

2. Procédé selon la revendication 1, **caractérisé en ce que** la valeur de la résistance du conducteur du chauffage par résistance ($H_1$, ..., $H_n$) et/ou la valeur de la résistance de la disposition de résistance ($RM_1$, ..., $RM_n$) sont changées par modification de matière, de préférence par ablation ou application de matière.

3. Procédé selon la revendication 1, **caractérisé en ce que** la valeur de la résistance est modifiée par ablation par laser.

4. Procédé selon la revendication 1, **caractérisé en ce que** la valeur de la résistance est modifiée par traitement thermique,

5. Procédé selon la revendication 1, **caractérisé en ce que** la valeur de la résistance est modifiée par traitement chimique ou électrochimique.

6. Procédé selon la revendication 1, **caractérisé en ce que** la valeur de la résistance est modifiée par implantation de particules, radiation électromagnétique ou radiation de particules.

7. Procédé selon la revendication 1, **caractérisé en ce que** la valeur de la résistance est modifiée par un signal électrique.

8. Procédé selon la revendication 1, **caractérisé en ce que** la valeur de la résistance de la disposition de résistance ($RM_1$, ..., $RM_n$) est modifiée par des techniques de la commutation.

9. Procédé selon l'une des revendications précédentes, **caractérisé en ce que** ledit procédé est effectué à des intervalles réguliers.

Fig. 1

gezeichnet für Kanal q

Widerstandsheizung

Fig. 2a

Fig. 2b

EP 0 956 625 B1

Fig. 2c

EP 0 956 625 B1

Fig. 3

Fig. 4a

Zusammenhang zwischen eingestelltem binären Wert (Index)
und der Heizleistung

relative Schrittweite

Leistung in mW

Index

Fig. 4b

## Zusammenhang zwischen eingestelltem binären Wert ( Index) und der Heizleistung

Fig. 4c

Zusammenhang zwischen eingestelltem binären Wert (Index) und der Heizleistung

Fig. 4d

Fig. 5a

Zusammenhang zwischen binären Wert (Index)
und der Heizleistung für Ausführungsbespiel 5a

Fig. 5b

Bondverbindung B

Fig. 6

EP 0 956 625 B1

23

Fig. 7

K2  K1  K8  K7  K14  K13

H1  L1  H2  H3  L2  H4  H5  L3  H6  A

K3  K4  K9  K10  K15  K16  B

A  K5  K11  K17

RV
RIV
RII
RI
RIV
RIII

K6  K12  K18

$U_0$

Fig. 8

EP 0 956 625 B1

Bondverbindung B

Fig. 9

EP 0 956 625 B1

Bondverbindung B

Fig. 10

EP 0 956 625 B1

Fig. 11

Bondverbindung B

Bondverbindung B

Fig. 12a

Fig. 12b